# FASCICULE DE BREVET EUROPEEN

(11) **EP 0 696 351 B1**
(45) Date de publication et mention de la délivrance du brevet: **02.01.1997**
(21) Numéro de dépôt: 94915193.0
(22) Date de dépôt: 29.04.1994
(51) Int. Cl.: G01N 3/04, H01J 37/20

(54) **MACHINE DE TRACTION IN SITU ET EPROUVETTE POUR MICROSCOPE ELECTRONIQUE A BALAYAGE**
EINE SICH IN EINEM RASTERELEKTRONENMIKROSKOP BEFINDLICHE ZUGVORRICHTUNG UND EIN PROBENKÖRPER
IN SITU TENSILE TESTING MACHINE AND SPECIMEN FOR A SCANNING ELECTRON MICROSCOPE

(30) Priorité: 30.04.1993 FR 9305169
(43) Date de publication de la demande: 14.02.1996
(73) Titulaire: CENTRE NATIONAL DE LA RECHERCHE SCIENTIFIQUE (CNRS), 75794 Paris Cédex 16 (FR)
(72) Inventeur: CHIRON, Rémi, F-95410 Groslay (FR); FRYET, Jacques, F-93000 Bobigny (FR); VIARIS DE LESEGNO, Patrick, F-95320 Saint-Leu-la-Forêt (FR)
(74) Mandataire: Michelet, Alain
(86) Numéro de dépôt international: FR9400495
(87) Numéro de publication internationale: WO9425846

(56) Documents cités:
- EP-A- 0 477 085
- DE-A- 2 930 805
- FR-A- 1 234 255
- FR-A- 2 248 751
- US-A- 3 107 522
- US-A- 3 919 558
- US-A- 4 721 000
- US-A- 5 056 372
- PATENT ABSTRACTS OF JAPAN vol. 16, no. 92 (P-1321) 6 Mars 1992 & JP,A,03 273 134 (SHIMADZU) 4 Décembre 1991
- PATENT ABSTRACTS OF JAPAN vol. 8, no. 72 (P-265) (1509) 4 Avril 1984 & JP-A-58 218 636 (TOKYO SHIBAURA DENKI)

## Description

La présente invention concerne une machine de traction in situ destinée à être intégrée dans la chambre d'observation d'un microscope électronique à balayage (M.E.B.), et à recevoir une éprouvette interposée entre deux éléments d'accrochage aptes à autoriser une traction sur ladite éprouvette par ses extrémités, en vue de l'étude de son comportement.

Il s'agit, par exemple, de faire des observations au microscope électronique à balayage pour suivre la chronologie des évènements lors de la déformation plastique des matériaux (endommagement, localisations des déformations, ...).

Ceci permet d'observer, à l'échelle microscopique, l'apparition et l'évolution de lignes de glissement, de bandes de cisaillement, de décohésions interfaciales, de fissures, ou encore d'hétérogénéités de déformations dans les polycristaux.

Parmi les expérimentations utilisant les essais de traction in situ, à température ambiante, peuvent être citées plus particulièrement :
1) l'étude des composites à matrice métallique, en particulier à matrice aluminium et à renfort de particules de carbure de silicium (SiC), dans lesquels l'intérêt porte plus particulièrement sur les mécanismes locaux d'endommagement, notamment au niveau de l'interface matrice-SiC ;
2) l'étude des matériaux à très hautes caractéristiques mécaniques élaborés par métallurgie des poudres, dans lesquels l'intérêt porte plus particulièrement sur la nocivité d'inclusions exogènes, introduites lors de l'élaboration ;
3) l'étude des instabilités de déformation plastique en bandes de cisaillement dans les mono-, multi- et polycristaux ;
4) l'étude des hétérogénéités de déformation plastique dans les polycristaux, afin de caractériser les mécanismes de déformation plastique des agrégats polycristallins.

A l'heure actuelle, les machines de traction produisant des forces élevées sont volumineuses et ne permettent donc pas de caractériser un matériau, lors de sa déformation, par son analyse au microscope électronique à balayage. Or, de ce qui précède, il est clairement mis en évidence l'intérêt scientifique d'une telle caractérisation, notamment pour l'étude de certains matériaux "technologiques", pour la confrontation à l'expérience de certains modèles de comportement, ou encore pour l'étude d'instabilités ou d'hétérogénéités de déformation.

Par ailleurs, les dispositifs in situ actuellement commercialisés ne peuvent pas remplacer les machines classiques, notamment du fait d'une rigidité mécanique moins bonne, ou d'un système d'accrochage de l'éprouvette moins performant, ou d'un contrôle moins précis des déplacements mécaniques des têtes de traction conduisant à des essais généralement moins propres.

Ces dispositifs sont en outre lourds et encombrants, nécessitant de changer la porte d'accès à la chambre du M.E.B., ou bien ils ne sont que partiellement modulaires, car le moteur assurant la traction sur l'éprouvette est placé à l'extérieur de la chambre, afin d'éviter les effets de perturbation magnétique du faisceau électronique, ou bien ils ne permettent pas d'imposer une charge nominale suffisante.

Egalement, il est important de mentionner que les systèmes d'accrochage de l'éprouvette, généralement adoptés, se composent soit de mors autoserrants, ce qui ne garantit ni l'auto-alignement, ni l'absence de glissement dans les têtes de l'éprouvette, soit d'un brochage de l'éprouvette dans une chape. Ces deux systèmes ne permettent pas d'isoler thermiquement l'éprouvette ; les essais à haute température ne sont alors permis que sur des éprouvettes de longueur utile importante et à faible section, de façon à minimiser la conduction de chaleur de la zone utile chauffée vers les têtes d'accrochage de l'éprouvette. Ces systèmes d'accrochage présentent donc une limitation importante aux essais de traction à haute température sur éprouvettes massives, du fait d'une conduction thermique trop grande vers les têtes de fixation et le bâti de la machine ; pour atteindre des températures importantes (> 600° C), il faudrait alors une puissance de chauffage importante, et accepter, lors d'essais de longue durée, un échauffement important des têtes de fixation et du reste de la machine, ce qui pourrait conduire à terme à une dégradation irréversible des caractéristiques de celle-ci.

Ainsi, le brevet JP-A-03273134 décrit un appareil d'essai de matière comprenant un microscope électronique à balayage. Une éprouvette est serrée entre une pince attenante à une partie fixe du dispositif et une pince de chargement. Ces pinces ou mors maintiennent l'éprouvette par pincement.

Par ailleurs, le brevet EP-A-0.477.085 décrit quant à lui un dispositif d'essai en traction et compression sur une éprouvette après simulation de rentrée en atmosphère. Une éprouvette soumise à essai est réalisée à partir d'une pastille dans laquelle ont été réalisées deux encoches en forme de demi-lune, et prend appui sur deux épaulements en arc de cercle situés à la base d'une mordache présentant une plaque d'appui striée.

Le fait de réaliser des essais à haute température sur éprouvette massive présente un intérêt scientifique certain pour de nombreux axes de recherche dans le domaine de la mécanique et de la métallurgie physique, en particulier :
- étude de la plasticité, à moyenne et haute température, des monocristaux et agrégats métalliques, dans le but de caractériser les mécanismes intra et intergranulaires de la déformation en fonction de la température ;
- étude de la plasticité des matériaux "technologiques" utilisés à moyenne ou haute température, tels par exemple les monocristaux de superalliage à phase précipitée Ni/Ni₃ Al étudiés à 650° C, température de service des pieds d'aubes de turbines de réacteurs d'avions.

La présente invention a pour objectif de remédier aux différents problèmes évoqués ci-dessus en proposant une machine de traction réunissant partiellement les avantages des machines classiques et ne présentant pas les inconvénients d'autres machines d'essai in situ (encombrement, et/ou absence de modularité, faible rigidité, système d'accrochage de l'éprouvette peu performant), tout en autorisant un chauffage de l'éprouvette sans conséquence pour la machine.

Un dispositif d'inversion associé à la machine de l'invention permet également son utilisation, dans un mode de réalisation préférentiel, comme machine de compression in situ.

A cet effet, l'invention concerne une machine de traction in situ destinée à être placée dans la chambre d'observation d'un microscope électronique à balayage (M.E.B.) et à recevoir une éprouvette interposée entre deux éléments d'accrochage aptes à autoriser une traction dans une direction sur ladite éprouvette par ses extrémités, en vue de l'étude de son comportement.

Elle se compose d'un bâti rigide sur lequel sont disposées deux têtes de traction, dont l'une au moins est mobile, définissant chacune un logement dans lequel est susceptible de s'ancrer l'extrémité correspondante de l'éprouvette par l'intermédiaire de deux épaulements formant un étranglement s'opposant au glissement de l'extrémité de l'éprouvette dans la direction de la traction pour assurer son autoblocage, de manière à constituer un ensemble de traction modulaire et compact, intégrable sans modification dans la chambre d'observation du M.E.B.

Cet aspect modulaire et compact de la machine peut également permettre de l'adapter dans d'autres systèmes de caractérisation (microscopie optique, appareil de diffraction X, ...).

La présente invention concerne également les caractéristiques ci-après, considérées isolément ou selon toutes leurs combinaisons possibles.

Les extrémités de l'éprouvette prennent respectivement appui sur les épaulements d'une tête de traction correspondante, par l'intermédiaire de deux pions formant galets, montés librement entre chacun desdits épaulements et une partie latérale correspondante en vis-à-vis de l'extrémité de l'éprouvette, de manière à assurer son auto-alignement simultanément à son autoblocage.

Avantageusement, les pions sont constitués par des cylindres de section semi-circulaire, dont le plan diamétral prend appui symétriquement sur chacun des épaulements respectifs des têtes de traction, les parties semi-circulaires desdits pions coopérant quant à elles avec des parties latérales de portées cylindriques à section semi-circulaire de rayon identique à celui des pions, réalisées de part et d'autre de chaque extrémité de l'éprouvette.

Dans ce cas, chacun des épaulements de chaque tête de traction est incliné vers l'axe longitudinal d'une éprouvette en place, de manière à lui assurer un autoblocage par effet de coin s'effectuant simultanément à son auto-alignement.

Les épaulements de chaque tête de traction forment un angle de 45° avec l'axe longitudinal de traction.

Selon une autre caractéristique de l'invention particulièrement utile, lors des essais à haute température, les pions interposés librement entre les têtes de traction et les extrémités de l'éprouvette présentent des propriétés de résistance à la compression et d'isolation thermique de l'éprouvette proprement dite.

Dans ce but, le matériau constitutif des pions est alors une céramique.

Préférentiellement, la céramique est un oxyde de zirconium ZrO2 stabilisé à la magnésie MgO autorisant un champ d'application dans une gamme de températures allant de 0 à 800° C.

Selon une autre caractéristique de l'invention, une vitesse de traction constante est obtenue par un moteur à courant continu, asservi en vitesse grâce à une centrale tachymétrique et un système électronique d'asservissement de vitesse, et par l'intermédiaire d'un ensemble réducteur dont la force en résultant est transmise à la tête de traction mobile par un système vis-écrou.

Le moteur est intégré avec le module qu'il constitue et comporte un blindage magnétique.

Egalement, des capteurs de force et de déplacement permettent d'obtenir, durant un essai, l'enregistrement de la force en fonction de la déformation.

Cet ensemble réducteur a un rapport de 3000:1.

Selon une autre caractéristique de l'invention, la machine comporte des moyens lui permettant d'être utilisée avec une inclinaison variable de 0 à 70°, à la distance de travail minimum de 30 mm ; à l'inclinaison maximale de 70°, il devient alors possible d'avoir accès localement au cours de la déformation, conjointement au champ de déformation obtenu grâce à l'utilisation d'une technique de micro-extensométrie, au champ de rotation cristalline de l'éprouvette obtenu grâce à l'analyse de la texture cristallographique de proximité, par diffraction des électrons rétrodiffusés (système E.B.S.P.).

Selon une autre caractéristique de l'invention, la machine est fixée sur une platine standard du microscope électronique à balayage (M.E.B.) permettant d'en utiliser ses déplacements X, Y et Z, indépendants selon trois directions orthogonales.

Sa capacité de charge nominale est de 10 kN, avec une surcharge admissible pouvant aller jusqu'à 15 kN.

De plus, elle est interfacée avec un ordinateur.

Selon une autre caractéristique de l'invention, la machine permet d'effectuer des essais de traction à chaud de l'éprouvette par l'intermédiaire d'un dispositif de chauffage intégré au module qu'elle constitue.

Dans ce cas, le dispositif de chauffage est constitué par un four accroché par des épingles sous l'éprouvette et en étroit contact avec celle-ci dans une partie médiane, ladite éprouvette étant isolée thermiquement par rapport aux têtes de traction et à la machine en général, grâce aux pions intermédiaires en céramique, sur lesquels prend appui ladite éprouvette dans les têtes de traction.

Selon une autre caractéristique de l'invention, un premier thermocouple de mesure et de régulation de température est placé entre le four et l'éprouvette, et un deuxième thermocouple permet de mesurer la température des têtes de traction.

Afin d'être utilisable comme machine de compression in situ, la machine de l'invention peut être équipée d'un dispositif d'inversion recevant la traction appliquée par la machine et appliquant une compression à une éprouvette. Ce dispositif d'inversion comporte deux mâchoires de compression ancrées chacune dans l'une des têtes de traction et ayant un doigt en forme de L, opposés l'un à l'autre, entre lesquels l'éprouvette peut être placée.

L'invention sera mieux comprise et d'autres caractéristiques de celle-ci seront mises en évidence à l'aide de la description qui suit, en référence aux dessins schématiques annexés, illustrant, à titre d'exemple non limitatif, comment l'invention peut être réalisée, et dans lesquels :
- la Figure 1 représente schématiquement en perspective une machine de traction selon l'invention ;
- les Figures 2, 3 et 4 représentent, respectivement en vue de face, de côté et de dessus, une machine selon la Figure 1, en position maximale d'inclinaison sur un microscope électronique à balayage (M.E.B.) ;

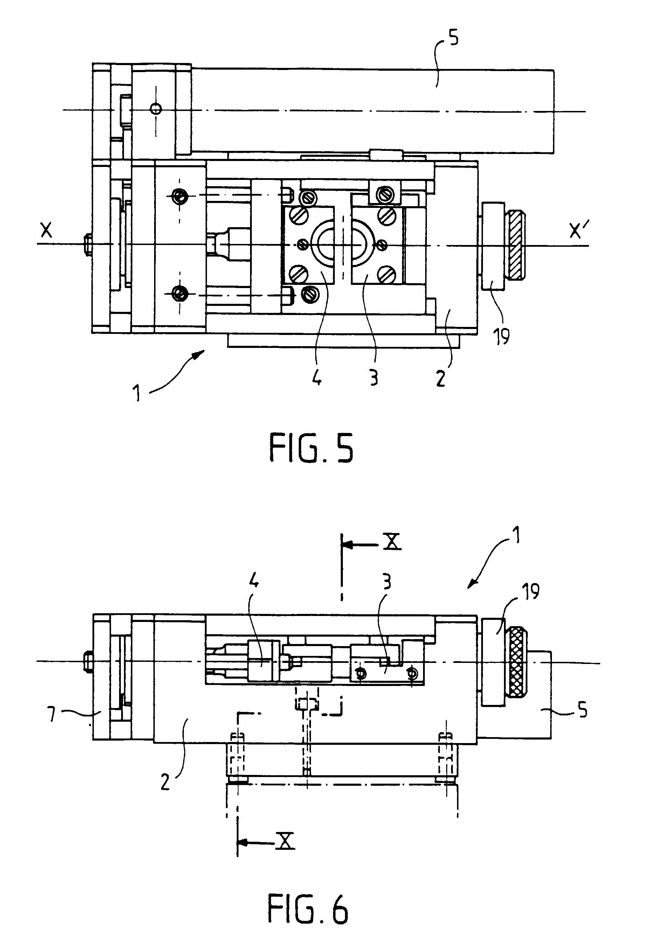

- la Figure 5 représente une vue en plan d'une machine de traction selon l'une des Figures précédentes ;
- la Figure 6 représente une vue latérale selon la Figure 5 ;
- la Figure 7 représente une vue en bout selon la Figure 6 ;
- la Figure 8 représente une vue en coupe selon une ligne VIII-VIII de la Figure 7 ;
- la Figure 9 représente une vue en coupe selon la ligne IX-IX de la Figure 7 ;
- la Figure 10 représente une vue en coupe selon la ligne X-X de la Figure 6 ;
- la Figure 11 représente une vue en coupe selon la ligne XI-XI de la Figure 7 ;
- la Figure 12 représente une vue de détail d'une tête de traction de la machine, dans laquelle est insérée une extrémité d'une éprouvette à tester ;
- la Figure 13 représente une vue en coupe selon la ligne XIII-XIII de la Figure 12 ;
- les Figures 14 et 15 sont des vues, respectivement en plan d'une machine de traction équipée d'un dispositif de chauffage de l'éprouvette, et en latéral, en coupe selon la ligne XV-XV de la Figure 14 ;
- la Figure 16 est une vue en plan de l'élément principal d'un échangeur de chaleur du dispositif de chauffage ;
- la Figure 17 est une vue latérale en coupe partielle selon la ligne XVII-XVII de la Figure 16 ;

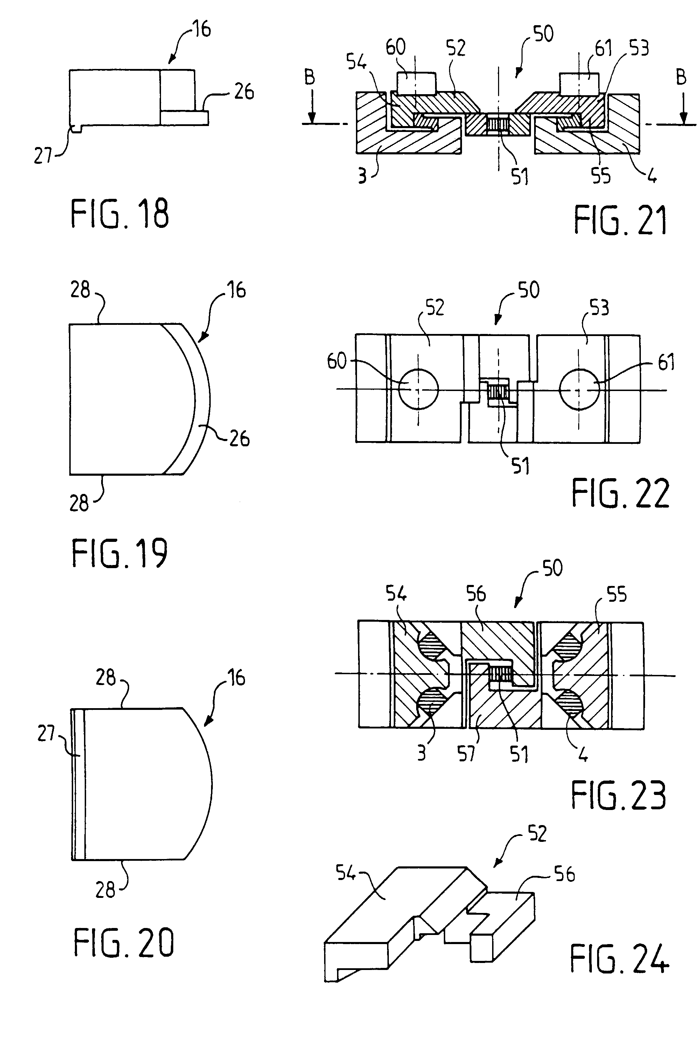

- les Figures 18, 19 et 20 sont des vues de côté, de dessus et de dessous d'un pion en céramique ZrO2/Mgo, à échelle agrandie, selon un exemple de réalisation ;
- les Figures 21 à 23 sont des représentations de la tête de traction équipée du dispositif d'inversion pour essai de compression, respectivement vue en coupe AA, de dessus et en coupe BB ;
- la Figure 24 est une vue en perspective de l'une des mâchoires de compression.

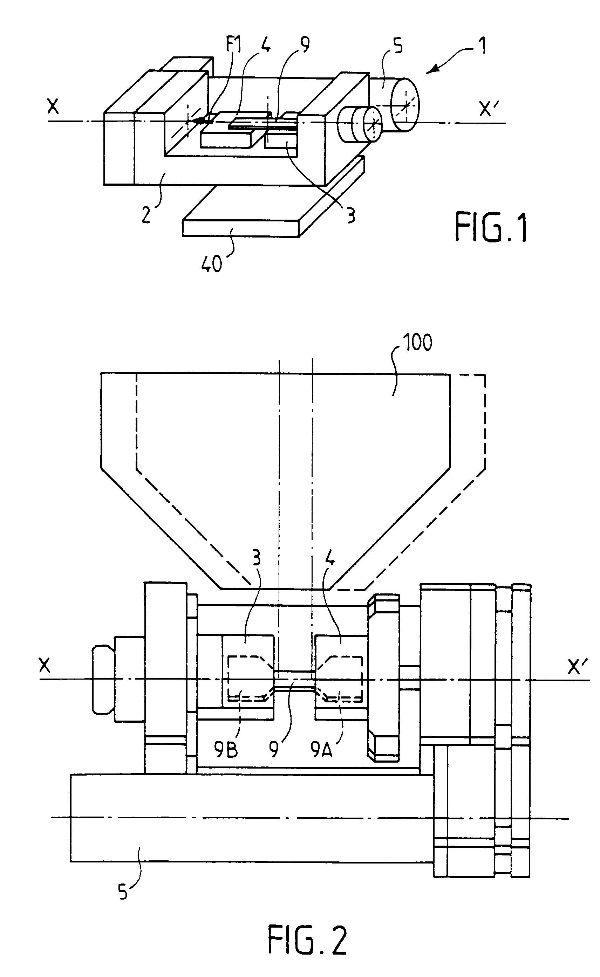

La machine de traction 1, désignée dans son ensemble et représentée schématiquement sur la Figure 1, se compose d'un bâti rigide 2 en forme de U, sur lequel sont disposées deux têtes de traction 3 et 4, dont l'une d'elles 4 est mobile selon un axe XX'.

Une vitesse de traction constante est obtenue par un moteur à courant continu 5, asservi en vitesse grâce à une centrale tachymétrique 6, désignée dans son ensemble, et par l'intermédiaire de deux réducteurs 7 et 8 interposés entre ladite centrale 6 et le moteur 5. La force résultant de l'ensemble réducteur est transmise à la tête de traction mobile 4 par un système vis-écrou 30.

Les têtes de traction 3 et 4 définissent des logements, respectivement 3A et 4A, dans lesquels sont susceptibles de s'ancrer les extrémités 9A, 9B de l'éprouvette 9.

Cet ancrage est effectué par l'intermédiaire de deux épaulements 10 et 11 pour le logement 4A, et 12 et 13 pour le logement 3A, formant respectivement des étranglements 14 et 15 s'opposant au glissement des extrémités 9A, 9B de l'éprouvette 9 dans un sens de traction F1, assurant son autoblocage.

La machine 1, ainsi globalement constituée, est destinée à être intégrée dans la chambre d'observation du microscope électronique à balayage (M.E.B.) sans aucune modification de celle-ci, qui peut demeurer donc dans sa configuration et ses dimensions d'origine.

Pour cette même raison d'intégration absolue, le moteur 5 comporte un blindage magnétique 18.

L'éprouvette est usinée dans une plaque à faces parallèles. Elle comporte une zone centrale mince, dite zone utile, entre deux extrémités plus larges destinées à être ancrées aux têtes de traction.

Plus précisément, les extrémités 9A, 9B de l'éprouvette 9, ou du dispositif de compression, prennent respectivement appui sur les épaulements 10, 11 et 12, 13 d'une tête de traction correspondante 4 ou 3, par l'intermédiaire de deux pions 16 formant galets, montés librement entre chacun desdits épaulements et une partie latérale correspondante en vis-à-vis de l'extrémité 9A, 9B de l'éprouvette 9, de manière à assurer son auto-alignement simultanément à son autoblocage.

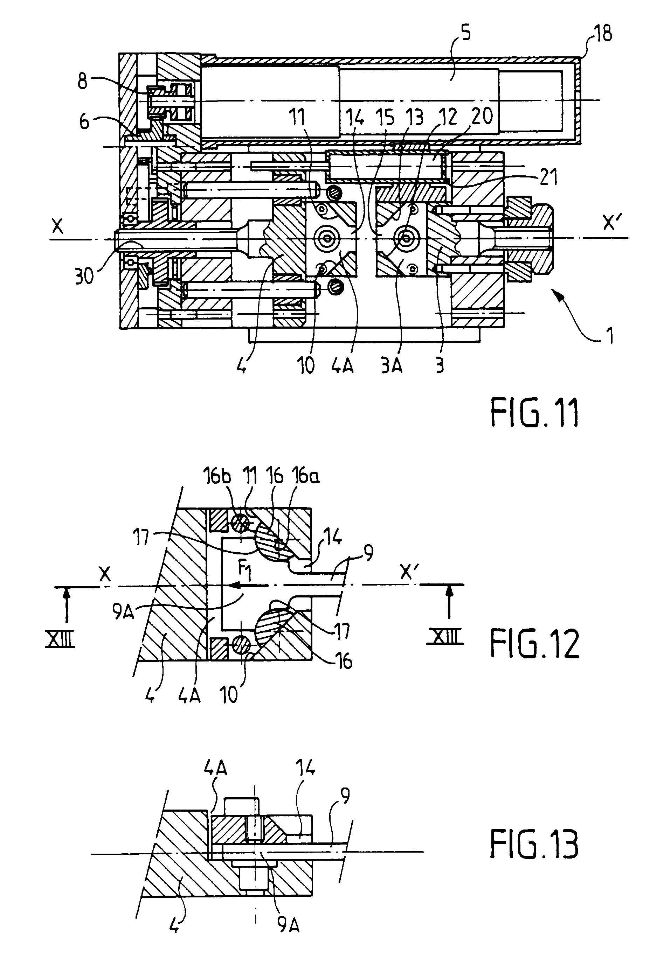

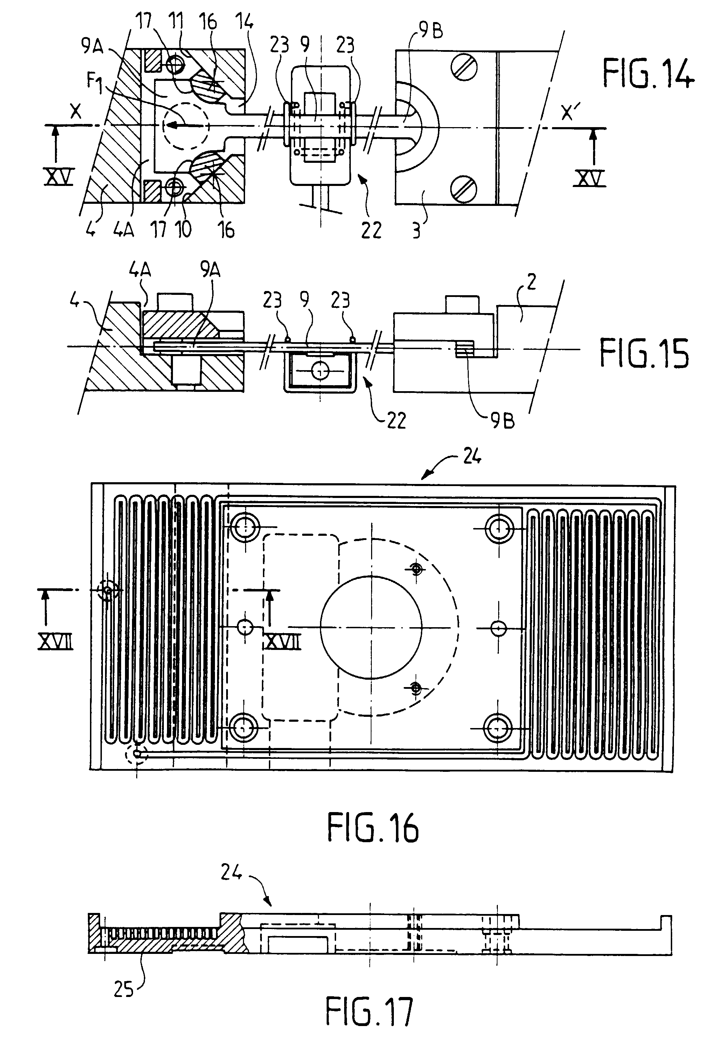

Selon l'exemple de réalisation représenté sur les Figures 12 ou 14, les pions 16 sont constitués par des demi-cylindres, dont le plan diamétral 16a prend appui symétriquement sur chacun des épaulements respectifs 10, 11 et 12, 13 des têtes de traction 4, 3, les parties semi-circulaires 16b desdits pions 16 coopérant quant à elles avec des parties latérales 17 de portée cylindrique et de rayon identique à celui des pions 16, réalisées de part et d'autre de chaque extrémité 9A, 9B d'éprouvette 9.

Chacun des épaulements 10, 11 et 12, 13 de chaque tête 4, 3 de traction est incliné vers l'axe longitudinal XX' d'une éprouvette en place 9, de manière à lui assurer un autoblocage par effet de coin s'effectuant simultanément à son auto-alignement.

Préférentiellement, les épaulements 10, 11 et 12, 13 de chaque tête de traction 4,3 forment, avec l'axe longitudinal XX', un angle de 45°.

Les quatre pions 16 interposés librement entre les têtes de traction 4, 3 et les extrémités 9A, 9B d'éprouvette 9, ou du dispositif de compression, présentent des caractéristiques de résistance à la compression et d'isolation thermique de l'éprouvette 9 proprement dite, ou du dispositif de compression.

Pour ce faire, le matériau constitutif des pions 16 est une céramique, constituée par un oxyde de zirconium ZrO2 stabilisé à la magnésie Mg O, autorisant un champ d'application dans une gamme de températures allant de 0 à 800° C, permettant des essais à chaud, comme il sera plus amplement évoqué plus loin.

La machine comporte également des capteurs de force et de déplacement permettant d'obtenir, durant un essai, l'enregistrement de la force en fonction de la déformation. Le capteur de déplacement 20 est également protégé par un blindage magnétique 21 en mumétal..

Selon un exemple de réalisation concret de la machine, pour les essais à température ambiante, les caractéristiques suivantes ont été obtenues :
. Rapport de l'ensemble réducteur: 3000:1
. Force nominale : 10 kN
. Force maximale : 15 kN
. Vitesse de déplacement : 0,01 à 30 µm/s
. Course : 1 = 21 mm
. Capteurs : force et déplacement
. Masse : 2 kg
. Encombrement : 15,5 x 9,5 x 4,5 cm3

Avant mise en service en laboratoire du premier prototype, deux essais de certification, à la charge maximale de 15 kN, ont été réalisés. Lors de la conception et pour répondre aux impératifs de poids, qui doit être le plus faible possible, et de résistance de la machine, les calculs classiques de résistance des matériaux ont été réalisés, à la traction et à la flexion notamment, conduisant à un dimensionnement et à un choix judicieux des matériaux (à la force nominale, le coefficient de sécurité retenu est de l'ordre de 5). Ainsi, le bâti 2 est en soloralu, alliage d'aluminium à haute résistance mécanique (AZ5GU, Rᵣᵤₚₜᵤᵣₑ = 540 MPa), et les têtes de fixation 4, 3 de l'éprouvette 9 et les parties mobiles (engrenages, vis de traction) sont en cuivre-béryllium (Cu-Be) traité (Rᵣᵤₚₜᵤᵣₑ = 1200 MPa).

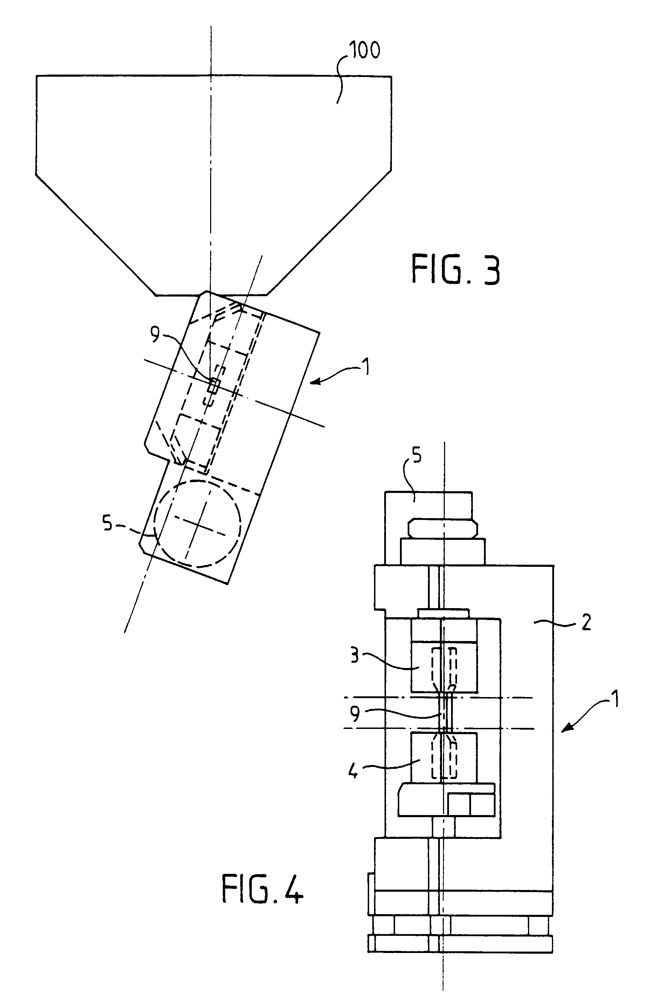

Une autre caractéristique de la machine suivant l'invention réside dans le fait qu'elle comporte des moyens lui permettant d'être utilisée avec une inclinaison variable de 0 à 70°, à la distance de travail minimum de 30 mm, permettant d'avoir accès localement au cours de la déformation, conjointement au champ de déformation, au champ de rotation de l'éprouvette 9, pour l'analyse de la texture cristallographique de proximité, par diffraction des électrons rétrodiffusés (système E.B.S.P.) (voir Figures 2, 3 et 4).

Ainsi, la machine peut être fixée sur la platine de déplacement du M.E.B., permettant d'en utiliser ses déplacements X, Y et Z, indépendants selon trois directions orthogonales.

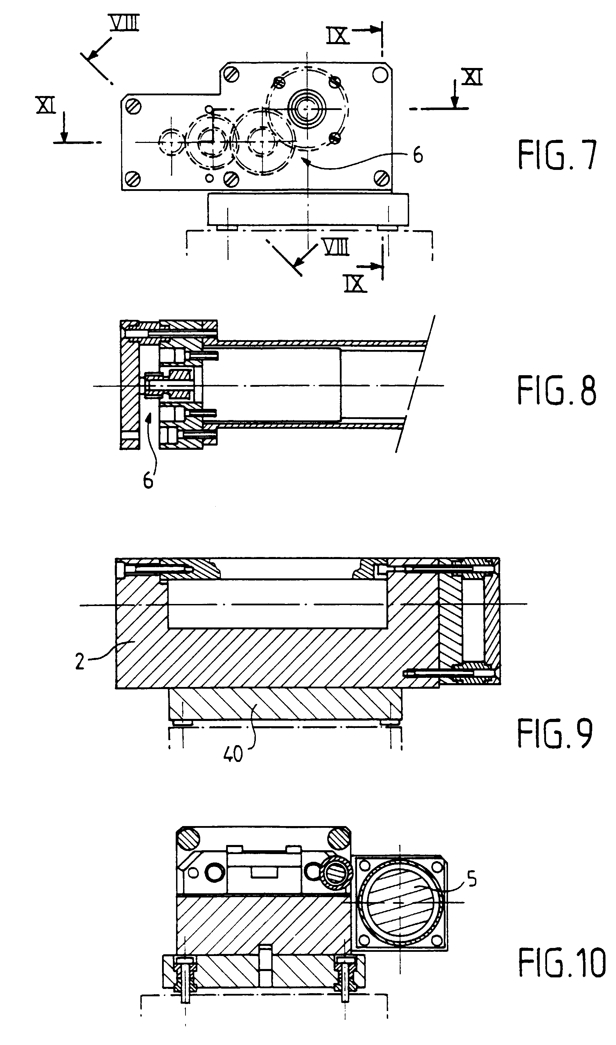

Cette fixation s'effectue par l'intermédiaire de la plaque 40 (Figure 9).

Egalement, la machine est interfacée avec un ordinateur. L'acquisition et le traitement informatisés des données (force et déplacement) peut, en particulier, permettre de réaliser des cycles de traction asservis à la contrainte ou à la déformation subies par l'éprouvette, en plus de l'utilisation normale à vitesse de déformation imposée.

Selon une variante de réalisation (Figures 14 et 15), un dispositif de chauffage 22, désigné dans son ensemble, est intégré au module constitué par la machine de traction.

Ce dispositif 22 est constitué par un four accroché par des épingles 23 sous l'éprouvette 9 et en étroit contact avec celle-ci dans une partie médiane, ladite éprouvette 9 étant isolée thermiquement des têtes de traction 4, 3, d'où de la machine en général, grâce aux pions intermédiaires en céramique 16 sur lesquels prend appui ladite éprouvette 9 dans les têtes de traction 4, 3.

Les caractéristiques techniques du four 22 sont les suivantes :
. Température nominale : 800° C
. Puissance nominale : 50 W
. Mesure température : par thermocouple
. Régulation température: par régulateur PID

Lors de l'utilisation du dispositif de chauffage, les caractéristiques de la machine sont limitées comme suit :
. Force nominale : 5 kN
. Force maximale : 10 kN
. Course : 1 = 10 mm

Le four de chauffage 22, accroché par des épingles 23 sous l'éprouvette 9, est en étroit contact avec celle-ci.

Un premier thermocouple de mesure (et de régulation) de température est placé entre le four et l'éprouvette, et un deuxième thermocouple permet de mesurer la température des têtes de fixation de l'éprouvette 9.

Pour la réalisation d'essais de longue durée à haute température, il est nécessaire de refroidir l'ensemble de la machine (sous vide, et compte tenu des caractéristiques dimensionnelles de l'éprouvette et du four, la chaleur se dissipe principalement par conduction), afin d'éviter un échauffement trop important, notamment au niveau des têtes de fixation de l'éprouvette 9 et des capteurs de force 19 et de déplacement 20.

Les Figures 16 et 17 représentent l'élément principal d'un système de refroidissement 24 constituant le radiateur 25 servant à évacuer les calories : il est conçu de telle sorte que la température des têtes de fixation de l'éprouvette 9 ne dépasse pas 50° C et ce, en utilisant de l'air à fort débit comme fluide caloporteur.

Afin de réaliser des essais de traction in situ à haute température, il est nécessaire d'isoler thermiquement l'éprouvette 9 du reste de la machine. Pour cela, il a été utilisé le principe du système original de fixation déjà décrit (quatre demi-pions s'appuyant sur des pans inclinés à 45°), mais en modifiant la nature et la forme des quatre demi-pions, de façon à isoler thermiquement l'éprouvette 9 par rapport aux têtes de fixation 4, 3.

Les pions ont été réalisés en céramique de type oxyde de zirconium ZrO₂ dopé à la magnésie MgO ; ce matériau présente les meilleures caractéristiques de résistance à la compression (il doit résister à la compression résultant de la mise en charge de l'éprouvette) et d'isolation thermique dans le domaine 0 à 800° C.

La température maximale (800° C) de fonctionnement du dispositif résulte d'un compromis entre les besoins des utilisateurs et l'influence de la température de l'éprouvette sur le bon fonctionnement du microscope (notamment les détecteurs), du fait de l'importance croissante du rayonnement lorsque la température augmente.

Comme déjà évoqué, les quatre demi-pions en ZrO₂/MgO ont une double fonction :
- permettre l'application de la charge sur l'éprouvette 9 : ils doivent présenter, à la température maximale de 800° C, une résistance à la compression supérieure à 500 MPa (elle est donnée pour être supérieure à 1800 MPa à 20° C) ;
- isoler thermiquement l'éprouvette 9 du reste de la machine de façon efficace (à 800° C, la conductivité thermique k de ZrO₂/MgO est inférieure à 2 Wm⁻¹K⁻¹) et géométriquement simple : l'éprouvette, qui ne doit pas toucher les têtes de fixation 4, 3 métalliques au cours de l'essai, doit être mise en place aussi facilement que pour les essais classiques à température ambiante.

Pour atteindre ce double objectif, les pions 16 présentent, à leur partie inférieure, un épaulement semi-périphérique 26 interdisant à l'éprouvette 9 en place contre lesdits pions 16 de venir en contact thermique avec le fond des logements 4A ou 3A des têtes 4 ou 3.

Une autre particularité des pions 16 réside dans le fait que leur portée sur le fond des logements 4A ou 3A ne s'effectue que par l'intermédiaire d'un talon 27. Ainsi, non seulement le contact thermique avec les têtes de traction est strictement limité au talon, mais de plus le pivotement possible des pions 16 autour de ce talon selon F2, lors de la traction, favorise leur auto-alignement.

La partie cylindrique des pions en céramique 16 est réduite au profit de deux ailes latérales parallèles 28 délimitant ainsi une section de la base plus faible, afin de diminuer la conduction thermique vers les têtes d'accrochage de l'éprouvette.

La machine de traction de l'invention a jusqu'à présent été décrite dans son utilisation première pour appliquer une traction sur l'éprouvette 9. Toutefois, en équipant cette machine d'un dispositif d'inversion 50, elle peut être utilisée pour appliquer, à une éprouvette 51, des efforts de compression.

Il est ainsi possible d'étudier sous microscope électronique une éprouvette soumise à des efforts de compression avec tous les avantages mentionnés plus haut : application d'efforts importants, compatibilité de la machine avec le volume de la chambre du MEB, ....

Le dispositif d'inversion 50 comprend deux mâchoires de compression 52, 53 comportant chacune une base 54, 55 ayant une forme analogue aux extrémités de l'éprouvette en traction 9 décrite plus haut et destinée à coopérer avec les têtes de traction 3 et 4.

Chacune de ces bases 54, 55 est solidaire d'un doigt 56, 57 ayant une forme de L.

Ces doigts sont opposés et imbriqués l'un dans l'autre, tels que représentés sur les Figures 24 à 27, de manière à permettre l'interposition de l'éprouvette 51 entre eux.

Ainsi, l'effort de traction appliqué sur les bases 54 et 55 des mâchoires de compression 52, 53 du dispositif d'inversion 50 produit des efforts de compression appliqués sur l'éprouvette 51.

Sans modification substantielle, la machine de l'invention permet donc également l'étude des effets des efforts de compression sous microscope électronique.

Des fours 60 et 61 peuvent être fixés sur les mâchoires de compression 52, 53.

L'énergie qu'ils fournissent, permet l'échauffement, essentiellement par conduction, de l'échantillon 51. il est donc ainsi possible d'étudier les efforts de compression à une température choisie éventuellement élevée.

## Revendications

1. Machine de traction in situ (1) destinée à être placée dans la chambre d'observation d'un microscope électronique à balayage (M.E.B.), et à recevoir une éprouvette interposée entre deux éléments d'accrochage aptes à autoriser une traction dans une direction sur ladite éprouvette par ses extrémités, en vue de l'étude de son comportement, comportant un bâti rigide (2) sur lequel sont disposées deux têtes de traction (3, 4), dont l'une au moins (4) est mobile, définissant chacune un logement (3A, 4A) dans lequel est susceptible de s'ancrer l'extrémité correspondante (9A, 9B) de l'éprouvette (9) par l'intermédiaire de deux épaulements (10, 11 et 12, 13) formant un étranglement (14, 15) s'opposant au glissement de l'extrémité de l'éprouvette (9) dans la direction de la traction (F1),
caractérisée en ce que les extrémités (9A, 9B) de l'éprouvette (9) prennent chacune appui sur les épaulements (10, 11 et 12, 13) d'une tête de traction correspondante (4 ou 3), par l'intermédiaire de deux pions (16) formant galets, montés librement entre chacun desdits épaulements et une partie latérale correspondante (17) en vis-à-vis de l'extrémité (9A, 9B) de l'éprouvette (9).

2. Machine selon la revendication 1, caractérisée en ce que les pions (16) sont constitués par des cylindres de section semi-circulaire, dont le plan diamétral (16a) prend appui symétriquement sur chacun des épaulements respectifs (10, 11 et 12, 13) des têtes de traction (4, 3), les parties semi-circulaires (16b) desdits pions (16) coopérant quant à elles avec des parties latérales (17) de portées cylindriques à section semi-circulaire de rayon identique à celui des pions (16), réalisées de part et d'autre de chaque extrémité (9A, 9B) d'éprouvette (9).

3. Machine selon la revendication 2, caractérisée en ce que chacun des épaulements (10, 11 et 12, 13) de chaque tête de traction (4, 3) est incliné par rapport à l'axe longitudinal de traction (XX').

4. Machine selon l'une des revendications 2 ou 3, caractérisée en ce que les épaulements (10, 11 et 12, 13) de chaque tête de traction (4, 3) forment, avec l'axe longitudinal de traction (XX'), un angle de 45°.

5. Machine selon l'une des revendications 1 à 4, caractérisée en ce que les quatre pions (16), interposés librement entre les têtes de traction (4, 3) et les extrémités (9A, 9B) d'éprouvette (9), présentent d'excellentes propriétés de résistance à la compression et d'isolation thermique de l'éprouvette (9).

6. Machine selon la revendication 5, caractérisée en ce que le matériau constitutif des pions (16) est une céramique.

7. Machine selon la revendication 6, caractérisée en ce que la céramique est un oxyde de zirconium ZrO2 stabilisé à la magnésie MgO.

8. Machine selon l'une quelconque des revendications 1 à 7, caractérisée en ce qu'une vitesse de traction constante est obtenue par un moteur à courant continu (5), asservi en vitesse grâce à une centrale tachymétrique (6) et un système électrique d'asservissement de vitesse, et par l'intermédiaire d'un ensemble réducteur (7, 8) dont la force résultante est transmise à la tête de traction mobile (4) par un système vis-écrou.

9. Machine selon la revendication 8, caractérisée en ce que des capteurs de force (19) et de déplacement (20) permettent d'obtenir, durant un essai, l'enregistrement de la force F en fonction de la déformation 1.

10. Machine selon l'une quelconque des revendications 1 à 9, caractérisée en ce qu'elle est destinée à être fixée sur une platine standard du microscope électronique à balayage (M.E.B.) permettant d'en utiliser les déplacements X, Y et Z, indépendants selon trois directions orthogonales.

11. Machine selon l'une quelconque des revendications 1 à 10, caractérisée en ce qu'elle comporte un dispositif de chauffage (22) intégré.

12. Machine selon la revendication 11, caractérisée en ce que le dispositif de chauffage (22) est constitué par un four accroché par des épingles (23) sous l'éprouvette (9) et en étroit contact avec celle-ci dans une partie médiane.

13. Machine selon la revendication 12, caractérisée en ce qu'un premier thermocouple de mesure et de régulation de température est placé entre le four (22) et l'éprouvette (9), et un deuxième thermocouple permet de mesurer la température des têtes de traction (4, 3).

14. Machine selon l'une quelconque des revendications 1 à 13, caractérisée en ce qu'elle comporte un dispositif d'inversion (50) recevant la traction appliquée par la machine et appliquant une compression à une éprouvette (51), le dispositif de compression comportant deux mâchoires de compression (52, 53) ancrées chacune dans l'une des têtes de traction et ayant chacune un doigt (56, 57) en forme de L, opposés l'un à l'autre, entre lesquels l'éprouvette (51) peut être placée.

## Patentansprüche

1. In-Situ-Zugvorrichtung (1) zum Anordnen in der Beobachtungskammer eines Rasterelektronenmikroskops (R.E.M) ) und zum Aufnehmen einer Probe, die zwischen zwei Halteeinrichtungen angeordnet ist, geeignet zum Aufbringen einer in einer Richtung wirkenden Zugkraft auf die Probe, um deren Verhalten zu untersuchen, wobei die Vorrichtung ein festes Gestell (2) aufweist, auf welchem zwei Zugköpfe (3, 4) angeordnet sind, von denen wenigstens einer (4) bewegbar ist, und die jeweils eine Aufnahme (3A, 4A) bilden, in der sich das entsprechende Ende (9A, 9B) der Probe (9) durch zwei Schultern (10, 11 und 12, 13) verankern kann, die eine Verengung (14, 15) bilden, welche einem Gleiten des Endes der Probe (9) in Zugrichtung (F1) entgegenwirkt,
dadurch gekennzeichnet, daß die Enden (9A, 9B) der Probe (9) sich über zwei Wälzkörper bildende Zapfen (16) jeweils an den Schultern (10, 11 und 12, 13) eines entsprechenden Zugkopfes (4 oder 3) abstützen, wobei die Zapfen frei zwischen jeder Schulter und einem dem Ende (9A, 9B) der Probe (9) gegenüberliegenden entsprechenden Seitenbereich (17) angeordnet sind.

2. Vorrichtung nach Anspruch 1, dadurch gekennzeichnet, daß die Zapfen (16) aus Zylindern mit halbkreisförmigem Querschnitt bestehen, deren Diametralebene (16a) symmetrisch an jeder der jeweiligen Schultern (10,11 und 12, 13) der Zugköpfe (4, 3) anliegen, wobei die halbkreisförmigen Teile (16b) der Zapfen (16) ihrerseits mit den Seitenteilen (17) zylindrischer Lagerflächen mit halbkreisförmigem Querschnitt zusammenwirken, die den selben Radius wie die Zapfen (16) aufweisen und an beiden Seiten jedes Endes (9A, 9B) der Probe (9) ausgebildet sind.

3. Vorrichtung nach Anspruch 2, dadurch gekennzeichnet, daß jede Schulter (10, 11 und 12, 13) jedes der Zugköpfe (4, 3) in bezug zur Längsachse (XX') der Zugwirkung geneigt ist.

4. Vorrichtung nach einem der Ansprüche 2 oder 3, dadurch gekennzeichnet, daß die Schultern (10, 11 und 12, 13) jedes Zugkopfes (4, 3) mit der Längsachse (XX') der Zugwirkung einen Winkel von 45° bilden.

5. Vorrichtung nach einem der Ansprüche 1 bis 4, dadurch gekennzeichnet, daß die zwischen den Zugköpfen (4, 3) und den Enden (9A, 9B) frei eingesetzten vier Zapfen (16) ausgezeichnete Druckfestigkeitseigenschaften und Eigenschaften der Wärmeisolierung der Probe (9) aufweisen.

6. Vorrichtung nach Anspruch 5, dadurch gekennzeichnet, daß das wesentliche Material der Zapfen (16) eine Keramik ist.

7. Vorrichtung nach Anspruch 6, dadurch gekennzeichnet, daß die Keramik ein durch Magnesiumoxid MgO stabilisiertes Zirkoniumoxid ZrO₂ ist.

8. Vorrichtung nach einem der Ansprüche 1 bis 7, dadurch gekennzeichnet, daß eine konstante Zuggeschwindigkeit durch einen Gleichstrommotor (5), der durch eine Drehzahlregelanlage (6) und ein elektrisches Geschwindigkeitsregelsystem geregelt ist, und über eine Untersetzungseinheit (7, 8) erhalten wird, deren resultierende Kraft auf den bewegbaren Zugkopf (4) über ein Spindelsystem übertragen wird.

9. Vorrichtung nach Anspruch 8, dadurch gekennzeichnet, daß die Kraft- (19) und Verschiebungssensoren (20) ermöglichen, während eines Versuchs die Kraft F in Abhängigkeit von der Verschiebung (1) aufzuzeichnen.

10. Vorrichtung nach einem der Ansprüche 1 bis 9, dadurch gekennzeichnet, daß sie zur Anbringung an einer Standardplatte eines Rasterelektronenmikroskops (R.E.M. ) vorgesehen ist, wodurch ermöglicht wird, die voneinander unabhängigen Verschiebungen X, Y und Z in drei orthogonalen Richtungen zu nutzen.

11. Vorrichtung nach einem der Ansprüche 1 bis 10, dadurch gekennzeichnet, daß sie eine integrierte Heizvorrichtung (22) aufweist.

12. Vorrichtung nach Anspruch 11, dadurch gekennzeichnet, daß die Heizvorrichtung (22) aus einem von Klammern (23) unter der Probe (9) und in einem Mittelbereich derselben in engem Kontakt mit der Probe gehaltenen Ofen besteht.

13. Vorrichtung nach Anspruch 12, dadurch gekennzeichnet, daß zwischen dem Ofen (22) und der Probe (9) ein erstes Thermoelement zum Messen und Regeln der Temperatur angeordnet ist und ein zweites Thermoelement das Messen der Temperatur der Zugköpfe (4, 3) ermöglicht.

14. Vorrichtung nach einem der Ansprüche 1 bis 13, dadurch gekennzeichnet, daß sie eine Invertiervorrichtung (50) aufweist, welche die von der Vorrichtung aufgebrachte Zugkraft aufnimmt und Druck auf eine Probe (51) aufbringt, wobei die Druckvorrichtung zwei Druckbacken (52, 53) aufweist, die jeweils in einem der Zugköpfe verankert sind und jeweils einen Finger (56, 57) in Form eines L aufweisen, die einander gegenüberliegen und zwischen welche die Probe (51) angeordnet werden kann.

## Claims

1. In situ tensile testing machine (1) designed to be placed in the observation chamber of a scanning electron microscope (S.E.M.), and to receive a specimen interposed between two anchoring elements capable of allowing traction in one direction of said specimen by its ends, with a view to studying its behaviour, comprising a rigid frame (2) on which are disposed two traction heads (3, 4) at least one (4) being movable, and each defining a cavity (3A, 4A) in which the corresponding end (9A, 9B) of the specimen (9) is capable of being anchored by means of two shoulders (10, 11 and 12, 13) forming a narrowing (14, 15) opposing the sliding of the end of the specimen (9) in the direction of traction (F1).
characterized in that the ends (9A, 9B) of the specimen (9) each bear upon the shoulders (10, 11 and 12, 13) of a corresponding traction head (4 or 3), by means of two slugs (16) forming rollers, mounted freely between each said shoulders and a corresponding side part (17) facing the end (9A, 9B) of the specimen (9).

2. Machine according to claim 1, characterised in that the slugs (16) are made up of cylinders of semi-circular section, the diametrical plane (16a) of which symmetrically bears upon each of the respective shoulders (10, 11 and 12, 13) of traction heads (4, 3), the semi-circular parts (16b) of said slugs (16) cooperating with side parts (17) having cylindrical bearing surfaces of semi-circular section of radius identical to that of the slugs (16), produced on either side of each end (9A, 9B) of specimen (9).

3. Machine according to claim 2, characterised in that each of the shoulders (10, 11 and 12, 13) of each traction head (4, 3) is inclined in relation to the longitudinal traction axis (XX').

4. Machine according to one of claims 2 or 3, characterised in that the shoulders (10, 11 and 12, 13) of each traction head (4, 3) form a 45° angle with the longitudinal traction axis.

5. Machine according to one of claims 1 to 4, characterised in that the four slugs (16), interposed freely between the traction heads (4, 3) and the ends (9A, 9B) of the specimen (9), have excellent properties of compressive strength and thermal insulation for the specimen (9).

6. Machine according to claim 5, characterised in that the constituent material of the slugs (16) is a ceramic.

7. Machine according to claim 6, characterised in that the ceramic is a zirconium oxide ZrO₂ stabilised with magnesia MgO.

8. Machine according to any one of claims 1 to 7, characterised in that a constant traction speed is obtained by a direct current motor (5), slaved in speed thanks to a tachometric unit (6) and an electric speed slaving system, and by means of a speed reducer (7, 8) whose output force is transmitted to the movable traction head (4) by a screw-nut system.

9. Machine according to claim 8, characterised in that force sensors (19) and displacement sensors (20) provide a means of obtaining, during a test, the recording of force F as a function of deformation 1.

10. Machine according to any one of claims 1 to 9, characterised in that it is designed to be fixed onto a standard stage of the scanning electron microscope (S.E.M.) allowing the X, Y and Z displacements to be used, independent in three orthogonal directions.

11. Machine according to any one of claims 1 to 10, characterised in that it comprises an integrated heating device (22).

12. Machine according to claim 11, characterised in that the heating device (22) is made up of an oven attached by pins (23) below the specimen (9) and in close contact with said specimen in a median part.

13. Machine according to claim 12, characterised in that a first temperature measuring and regulation thermocouple is placed between the oven (22) and the specimen (9), and a second thermocouple is used to measure the temperature of the traction heads (4, 3).

14. Machine according to any one of claims 1 to 13, characterised in that it comprises a reversing device (50) which receives the traction applied by the machine and applies compression to a specimen (51), the compression device comprising two compression jaws (52, 53) each anchored in one of the traction heads and each having an L-shaped finger (56, 57), facing one another, between which the specimen (51) can be placed.
